# EUROPÄISCHE PATENTSCHRIFT

(11) **EP 1 428 265 B1**
(45) Veröffentlichungstag und Bekanntmachung des Hinweises auf die Patenterteilung: **06.08.2008**
(21) Anmeldenummer: 02777171.6
(22) Anmeldetag: 20.09.2002
(51) Int. Cl.: H01L 31/048, H01L 31/02

(54) **PHOTOVOLTAIK-ISOLIERVERGLASUNG**
PHOTOVOLTAIC INSULATING GLAZING
VITRAGE ISOLANT PHOTOVOLTAIQUE

(30) Priorität: 21.09.2001 DE 10146498
(43) Veröffentlichungstag der Anmeldung: 16.06.2004
(73) Patentinhaber: GLASWERKE ARNOLD GmbH & Co. KG, 73630 Remshalden (DE)
(72) Erfinder: SCHMIDT, Christoph, 91710 Gunzenhausen (DE)
(74) Vertreter: Langöhrig, Angelika Beate
(86) Internationale Anmeldenummer: PCT/EP2002/010620
(87) Internationale Veröffentlichungsnummer: WO 2003/028114

(56) Entgegenhaltungen:
- EP-A- 0 199 233
- DE-A- 4 128 766
- DE-A- 4 402 449
- DE-U- 29 607 069
- US-A- 4 832 755

## Beschreibung

Die Erfindung betrifft eine Photovoltaik-Isolierverglasung umfassend eine mehrschichtige Verglasung mit einem Photovoltaik-Modul, wobei Kontaktbändchen zur Kontaktierung des Photovoltaik-Moduls aus dem Photovoltaik-Modul herausgeführt sind und wobei ein Abstandshalter zur Beabstandung der Glasschichten zur Bildung des Zwischenraums vorgesehen ist, der z. B. aus einer Profilschiene gebildet ist, wobei in dem Abstandshalter mindestens eine Öffnung vorgesehen ist, mittels derer das Kontaktbändchen und ein elektrisches Anschlusselement über einen Bolzen, der in die Öffnung eingesetzt ist, festgelegt sind und wobei das Kontaktbändchen mit dem außerhalb der Glasschichten vorgesehenen elektrischen Anschlusselement zusammenwirkt.

Die Verwendung von Photovoltaik-Modulen in Isolierverglasungen erfolgt über eine Glasschicht z. B. aus einem Doppelglas, in das die Solarzellen eingebettet bzw. auf das sie aufgebracht sind. Dieses Modul stellt in der Regel die eine Schicht der Isolierverglasung. Die andere wird durch eine Glasscheibe gebildet. Zwischen Glasscheibe und Photovoltaik-Modul besteht ein Scheibenzwischenraum, der zur Bildung einer Isolierverglasung mit Gas befüllbar ist. Eine solche Anordnung ist z. B. aus der EP 199 233 A1 bekannt. Die Erfindung umfasst jedoch auch andere Arten von Photovoltaik-Modulen.

Zur Herstellung von Photovoltaik-Isolierverglasungen ist es notwendig, eine elektrische Verbindung zwischen dem Photovoltaik-Modul der Isolierverglasung und der Außenseite der Isolierverglasung herzustellen. Insbesondere wenn Photovoltaik-Module verarbeitet werden, bei denen die elektrischen Anschlüsse, die sogenannten "Kontaktbändchen", durch Lochbohrungen der rückseitigen Modulabdeckung aus dem Photovoltaik-Modul austreten, bestehen Probleme, da dieses Kontaktbändchen dadurch innerhalb des Scheibenzwischenraums der Isolierverglasung verläuft. Die Kontaktbändchen bestehen hierbei aus einem dünnen Metallband. Die elektrische Anbindung an die externen Anschlüsse muss insbesondere folgende Anforderungen erfüllen:
- Gas- und Wasserdampfdichtigkeit,
- Zugentlastung der Modulanschlüsse,
- rückseitig geringe Bauhöhe von maximal 5 mm entsprechend der üblichen Dichtstoffüberdeckung eines Isolierglases,
- Kabelaustritt möglichst tangential zum Isolierglasrand,
- der Montageablauf muss sich optimal in die Isolierglasfertigung integrieren lassen.

Es ist neben der Lösung der EP 199 233 A1 auch bekannt, eine Kabeldurchführung vorzusehen, bei der die Anschlusskabel im Scheibenzwischenraum der Isolierverglasung an die Kontaktbändchen angelötet oder gequetscht werden und dann durch Lochbohrungen im Isolierglasabstandshalter aus der Scheibe geführt werden. Die oben genannten Anforderungen werden hierdurch jedoch nicht oder nur unzureichend erfüllt.

Eine weitere Lösung des elektrischen Anschlusses zeigt US-PS 4,832,755.

Es ist daher Aufgabe der vorliegenden Erfindung, eine Photovoltaik-Isolierverglasung bereitzustellen, bei der die elektrischen Anschlüsse auf einfache Weise mit den Kontaktbändchen verbunden sind und die oben genannten Anforderungen erfüllt werden.

Die Erfindung löst diese Aufgabe durch eine Photovoltaik-Isolierverglasung mit den Merkmalen des Anspruchs 1.

Dabei erfolgt die Herausführung des Kontaktbändchen aus dem Photovoltaik-Modul seitlich aus den Modulschichten. Der Abstandshalter kann dann entweder zwischen der inneren Modulabdeckung und der Glasscheibe oder zwischen der äußeren Modulabdeckung und der Glasscheibe angeordnet sein.

Sofern die Anordnung des Abstandshalters nach der zweiten Alternative erfolgt, muss die innere Modulabdeckung gegenüber der äußeren gekürzt sein. Die Festlegung des Kontaktbändchens erfolgt jedoch, wie nachstehend beschrieben.

Erfolgt die Anordnung des Abstandshalters nach der ersten Alternative, so tritt das Kontaktbändchen nicht in den Scheibenzwischenraum aus, sondern tritt ganz außerhalb der Isolierverglasung zutage. Die Festlegung erfolgt dann ebenfalls wie die des externen Anschlusselements "von außen", entweder durch Festlegung über einen Kabelschuh oder Einklemmen desselben zwischen Bohrungswandung und Bolzen.

Es ist dann besonders vorteilhaft, dass die Bohrung im Abstandshalter und/oder dem Verbinder nicht bis in den Scheibenzwischenraum durchgeht, sondern lediglich die äußere Seite eine Öffnung besitzt. Die Dichtigkeit des Scheibenzwischenraums wird dann nicht beeinträchtigt. Das Kontaktbändchen wird dann schließlich ebenfalls durch die Isolierung bei der fertigen Scheibe umschlossen.

Besonders vorteilhaft ist dabei, dass der elektrische Anschluss hierbei beim eingebauten bzw. schon bereits fertigen Fenster nicht mehr gesehen werden kann, da keine Bohrungen vorgenommen werden müssen, die in den Scheibenzwischenraum hineinragen.

Der Abstandshalter kann dabei einzelne Elemente sowie Verbindungselemente umfassen, wobei die einzelnen Elemente über die Verbindungselemente verbunden sind, wobei die Öffnungen dann Bohrungen in den Verbindungselementen sein können. Bei den Verbindungselementen kann es sich um handelsübliche Linear- oder Eckverbinder für Isolierglasabstandshalter mit Lochbohrung handeln, so dass kein zusätzlicher Herstellungsaufwand entsteht.

Alternativ kann in dem Abstandshalter selber eine oder mehrerer Bohrungen vorgesehen sein.

Es kann dabei vorgesehen sein, dass die Bohrung zugleich auch als Gasbefüllöffnung für das Isolierglas dient.

Es kann insbesondere vorgesehen sein, dass die Bohrung ein Gewinde aufweist und der Bolzen in sie hineingeschraubt ist. Wahlweise kann der Bolzen jedoch auch in die Bohrung hineingepresst werden.

Nach einer ersten Alternative kann vorgesehen sein, dass sich das Kontaktbändchen durch die Bohrung erstreckt und durch das Gewinde des Bolzens geklemmt wird.

Als elektrisches Anschlusselement kann hier beispielsweise ein Anschlusskabel mit einem Kabelschuh dienen, wobei das Kontaktbändchen mit dem Kabelschuh in direkter Verbindung steht. Der Bolzen kann hierbei beispielsweise eine Mutter aufweisen, bzw. einen Bolzenkopf, durch den der Kabelschuh zwischen der Wandung des Verbindungselementes und/oder des Abstandhalters und dem Kopf des Bolzens geklemmt und damit kraftschlüssig gehalten wird. Hierdurch wird das externe Anschlusselement festgelegt. Das Kontaktbändchen und damit der Modulanschluss selbst ist dann zugentlastet und die Öffnung im Abstandshalter und/oder Verbindungselement wird gleichzeitig verschlossen, so daß das in die Isolierglasscheibe eingefüllte Gas im Scheibenzwischenraum gehalten wird.

Je nach Ausgestaltung können die Bolzen aus elektrisch leitendem oder nichtleitendem Material bestehen und unterschiedliche Ausführungsformen, wie z. B. Blindniet, Spreizmuffe oder ähnliches aufweisen.

Nach einem weiteren Ausführungsbeispiel kann vorgesehen sein, dass in der Bohrung ein elastischer Dichtnippel vorgesehen ist, um den Glasscheibenzwischenraum gegenüber der Außenseite der Glasschichten abzudichten. Auf diese Weise kann die Gas-und Dampfdichtheit noch besser gewährleistet werden.

Die Verbinder können dabei aus Kunststoff bestehen. Es kann vorgesehen sein, dass die Abstandshalter, die aus beispielsweise Aluminiumhohlprofilen gebildet sind, auf die Verbinder aufgeschoben und dort verklemmt werden. Insbesondere kann hierbei eine Presspassung vorgesehen sein. Als elektrisches Anschlusselement kann ein Kabelschuh vorgesehen sein, an dem ein Anschlusskabel angebracht ist.

Sofern die Abstandshalter aus elektrisch leitendem Material bestehen, kann vorgesehen sein, dass nicht leitfähige Unterlegscheiben verwendet werden, um einen elektrischen Kontakt zwischen dem Bolzen und den Abstandsprofilen und dadurch Kurzschlüsse zu vermeiden.

Sofern die Öffnungen in dem Abstandshalterprofil selbst vorgesehen sind, ist eine elektrische Isolierung stets notwendig, sofern diese aus leitendem Material bestehen. Bei Kunststoffhohlprofilen kann hierauf verzichtet werden.

Um zu verhindern, dass die Anschlusskabel, die den Dichtstoff des Isolierglases schräg nach außen durchdringen, beim Ziehen am Anschlusskabel aus dem Dichtstoff herausgerissen werden können, bis zu der Stelle, an der der Kabelschuh mit dem Bolzen am Abstandshalter befestigt ist, wodurch das Photovoltaik-Isolierglas zerstört werden kann, kann vorgesehen sein, an der Stelle des Kabelaustritts einen Klotz, z. B. aus Kunststoff, vorzusehen, der ungefähr die Breite des Isolierglases aufweist, d. h. eine Breite umfasst, die in etwa der Breite der Glasscheiben, die den Scheibenzwischenraum zwischen sich einschließen, sowie des Scheibenzwischenraums selber entspricht. Dieser Klotz kann dann auf den noch nicht ausgehärteten Isolierglasdichtstoff aufgeklebt werden. Hierbei kann ein üblicher Verglasungsklotz mit vorzugsweise 0,5 bis 8 mm Dicke vorgesehen sein, der neben seiner Schutzfunktion für den Kabelaustritt auch gleichzeitig als Verglasungsklotz dienen kann.

Durch einen derartigen Klotz kann darüber hinaus auch verhindert werden, dass die Anschlusskabel beim Einbau zwischen Unterkonstruktion und Glas nicht eingequetscht werden.

Ein derartiger Klotz kann nutenförmige Aussparungen längs der Glaskante zur Aufnahme des Kabels aufweisen, die den zusätzlichen Vorteil einer erhöhten Dichtstoffüberdeckung im Bereich des elektrischen Anschlusses bieten. Darüber hinaus kann der Klotz an seiner dem Glas zugewandten Seite Überstände in Form von beispielsweise Widerhaken aufweisen, die sich bei Aufkleben des Klotzes in den Dichtstoff drücken und nach Aushärten des Dichtstoffes zu einem zusätzlichen Formschluss zwischen Klotz und Dichtstoff führen.

Die Bohrungen können dabei Stufenbohrungen sein.

Die Erfindung soll im Folgenden anhand von Ausführungsbeispielen näher erläutert werden.

Dabei zeigen:
- Figur 1:: eine Photovoltaik-Isolierverglasung;
- Figur 2:: die Montage des elektrischen Anschlusses nach einer ersten Ausgestaltung;
- Figur 3:: eine zweite Ausgestaltung eines elektrischen Anschlusses; und
- Figur 4: eine erfindungsgemäße Ausgestaltung einer PV- Isolierverglasung.

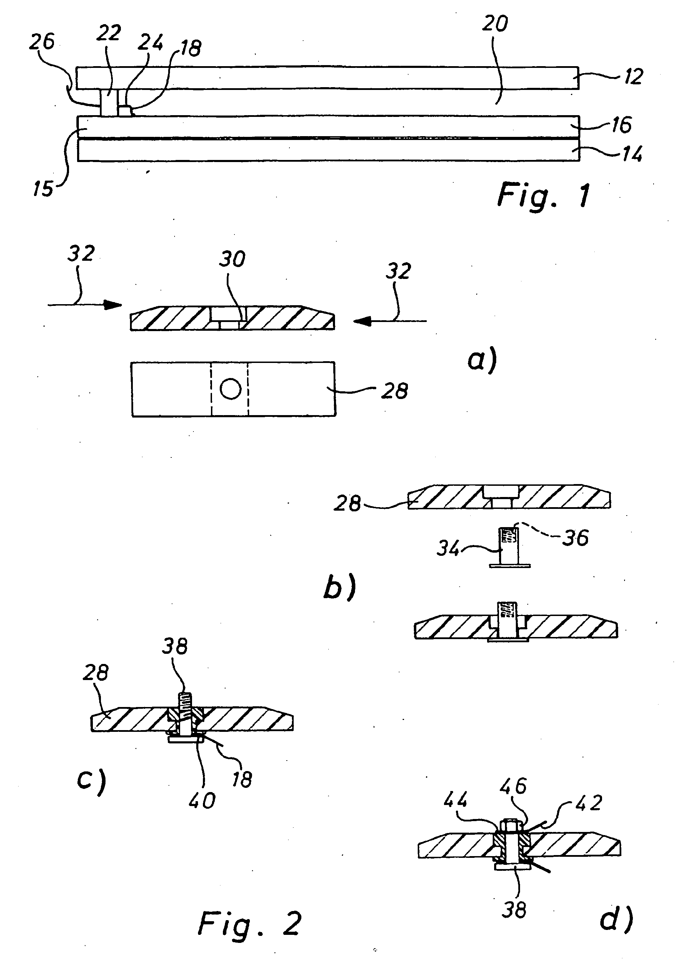

Figur 1 zeigt eine Isolierverglasung bestehend aus zwei äußeren Glasscheiben 12 und 14. Die Scheibe 14 bildet dabei die äußere Abdeckung eines Photovoltaik-Moduls 16. Die innere Abdeckung bildet die Scheibe 15. Zwischen den Scheiben 15, 16 sind die Solarzellen angeordnet.

Zur elektrischen Kontaktierung ist in dem Photovoltaik-Modul 16 als elektrischer Anschluss ein Kontaktbändchen 18 angeordnet. Das Kontaktbändchen 18 ist dabei durch eine Bohrung in der inneren Abdeckung 15 in den Scheibenzwischenraum 20 geführt.

Zur Bildung eines Scheibenzwischenraums 20 zwischen der Scheibe 15 und der Glasscheibe 12, der eine Isolierfunktion erfüllt, ist ein handelsüblicher Abstandshalter 22 vorgesehen, durch den der elektrische Anschluss aus dem Scheibenzwischenraum 20 nach außen geführt werden kann und dort mit einem elektrischen Anschlusselement 26, zumeist einem externen Kabel, in Kontakt gebracht werden kann. Der Scheibenzwischenraum 20 ist dabei wie bei Isolierverglasungen üblich gasgefüllt. Der elektrische Anschluss muss daher gas- und dampfdicht sein.

Die Abstandshalter 22 bestehen aus Aluminiumhohlprofilelementen, die durch Verbindungselemente 28 aus Kunststoff, wie sie in Figur 2 gezeigt sind, verbunden werden, indem auf beide Seiten eines Verbindungselementes 28 ein Aluminiumhohlprofil aufgeschoben und dort reibschlüssig gehalten ist. Die Verbindungselemente 28 weisen dabei eine Bohrung 30 auf.

Zur elektrischen Kontaktierung der Photovoltaik-Module 16 kann nun vorgesehen sein, dass das Verbindungselement 28 mit einer stufenförmigen Lochbohrung 30 versehen ist, wobei dies in Darstellung a) von Figur 2 zu ersehen ist. Darstellung a) von Figur 2 zeigt das entsprechende Verbindungselement 28 im Schnitt sowie die Unterseite desselben. In Pfeilrichtung 32 werden auf das Verbindungselement 28 die Hohlprofile des Abstandshalters 22 aufgeschoben.

In Darstellung b) wird nun gezeigt, wie ein spezieller Dichtnippel 34 aus elastischem Material mit integrierter Gewindemutter 36 in die Stufenbohrung 30 eingesteckt wird. Ein Gewindebolzen 38, der in Darstellung c) gezeigt ist, verklemmt durch Verschraubung mit der integrierten Gewindemutter 36 einerseits den Dichtnippel 34 mit dem Schaft des Gewindebolzens 38 und andererseits mit dem Verbindungselement 28 gasdicht.

Während des Verschraubens wird ein handelsüblicher Kabelschuh 40 an dem Gewindebolzen 38 befestigt, der zur elektrischen Kontaktierung eines Kontaktbändchens 18 des Photovoltaik-Moduls 16 dient. Das so ausgestattete Verbindungselement 28 wird in den Isolierglasabstandshalter 22 eingebaut, wobei ein Verbindungselement 28 pro Kontaktbändchen 18 verwendet wird.

Bei der Isolierglasproduktion selbst, d. h. dem Zusammenfügen der einzelnen Scheiben, ist als zusätzlicher Produktionsschritt damit lediglich die Klemmverbindung zwischen Kontaktbändchen und Kabelschuh herzustellen. Bei der Versiegelung des Isolierglases werden die Kontaktstellen zunächst ausgespart bzw. mit einer geeigneten Abdeckung versehen.

Im eingebauten Zustand wird nun, wie in Darstellung d) gezeigt ist, das externe Anschlusskabel als elektrisches Anschlusselement 42, das ebenfalls mit einem Kabelschuh 44 versehen ist, mittels einer Gewindemutter 46 an dem Gewindebolzen 38 festgelegt. Auf diese Weise wird eine gasdichte elektrische Verbindung zwischen dem Kontaktbändchen 18 und dem elektrischen Anschlusselement 42 über den Bolzen 38 sichergestellt.

Zugkräfte auf das elektrische Anschlusselement 42 werden in das Verbindungselement 28 und nicht in das Kontaktbändchen 18 eingeleitet, so dass dieses von Zugbelastungen frei ist. Darüber hinaus ist die Gas- und Wasserdampfdichtigkeit sichergestellt und der Glaszwischenraum 20 ist unabhängig von Umgebungseinflüssen.

Nach der Montage des externen Anschlusskabels wird der Anschluss mit Dichtstoff versiegelt und damit auch elektrisch isoliert.

Darüber hinaus werden zusätzlich nicht elektrisch leitfähige Unterlegscheiben unter den Kabelschuhen 44, 40 verwendet, um zu vermeiden, dass beim Zusammenstecken der Abstandshalterprofile 22, die aus einem metallischen Material bestehen können, mit den Verbindungselementen 28 ein elektrischer Kontakt zwischen Bolzen 38 und Abstandshalterprofilen 22 auftritt, der einen Kurzschluss verursachen könnte.

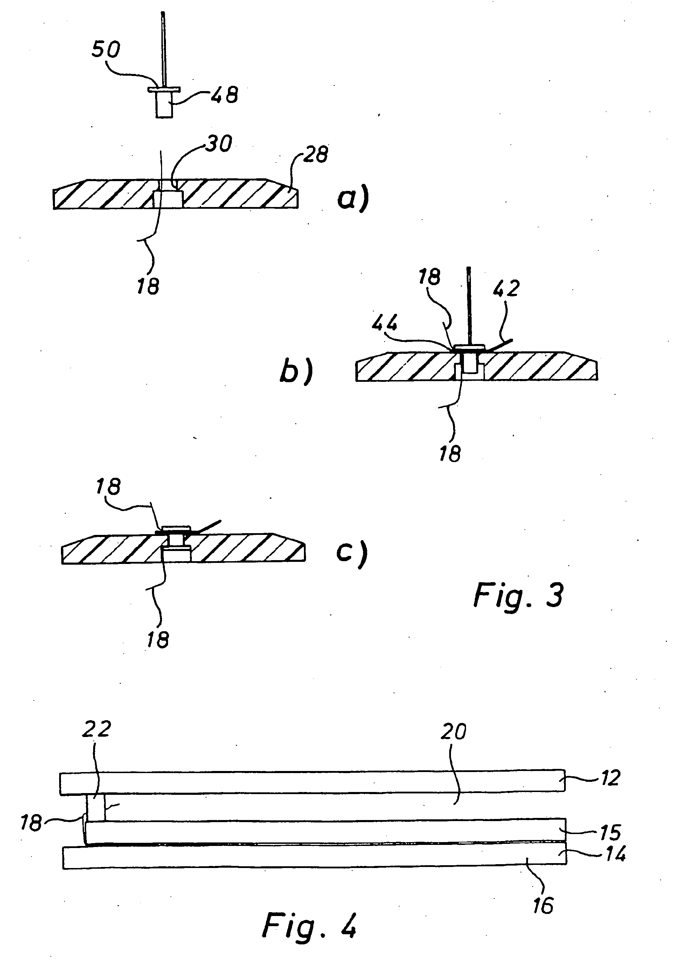

Figur 3 zeigt nun drei Darstellung a) bis c) einer weiteren Variante der elektrischen Kontaktierung, wobei gleiche Teile hier mit gleichen Bezugszeichen versehen sein sollen.

In dem Verbindungselement 28 ist hierbei wiederum eine Bohrung 30 vorgesehen, durch die das Kontaktbändchen 18 hindurchgefädelt wird. Als Bolzen dient hier ein Blindniet 48, unter dessen Kopf 50 ein Kabelschuh 44 geschoben wird. Der Kabelschuh 44 ist wiederum mit dem elektrischen Anschlusselement 42 verbunden. Der Blindniet 48 wird von außen in die Lochbohrung 30 eingesteckt und dort, wie in den Darstellungen b) und c) gezeigt ist, befestigt.

Hierbei wird der Kabelschuh 44, der den Blindniet 48 umgreift unter dem Kopf 50 des Blindniets 48 festgelegt und gleichzeitig das Kontaktbändchen 18 zwischen der Wandung der Bohrung 30 und dem Niet 48 eingeklemmt. Eine Übertragung von Zugkräften wirkt danach nicht länger auf das Kontaktbändchen 18. Darüber hinaus wird hierbei das Kontaktbändchen 18 mit dem elektrischen Anschluss 42 über den Kabelschuh 44 direkt kontaktiert und, wie gut in Darstellung c) gesehen werden kann, die Bohrung 30 verschlossen. Auf die elektrische Leitfähigkeit des Bolzens bzw. Blindniets kommt es dann nicht an.

Gegenüber der in Figur 2 gezeigten Alternative besitzt diese Lösung den Vorteil, dass die Montage der Niete 48 erst nach dem Zusammenbau der Isolierglasscheibe erfolgen kann. Die Lochbohrungen 30 können dann gleichzeitig als Gasbefüllöffnung des Isolierglases dienen.

Alternativ kann bei einem Aufbau wie bei Figur 1 vorgesehen sein, zwei Bohrungen vorzusehen, wobei das Kontaktbändchen 18 über eine erste Lochbohrung 30 aus dem Scheibenzwischenraum 20 herausgeführt wird, wobei die Lochbohrung 30 den Abstandshalter 22 vollständig durchdringt und nach Durchführung das Kontaktbändchen 18 mit einem Stopfen verschlossen wird, und daneben eine zweite Bohrung vorgesehen ist, die von der Außenseite des Abstandshalters her 22 insbesondere als Sackloch ausgebildet ist. In dieser zweiten Bohrung kann dann, wie analog zu Figur 4 beschrieben, die Festlegung des Bändchens 18 und die Kontaktierung erfolgen.

Figur 4 zeigt nun eine erfindungsgemäße Variante, bei der das Kontaktbändchen 18 von außen an den elektrischen Anschluss herangeführt ist.

Hierbei ist der Abstandshalter 22 zwischen der inneren Modulabdeckung 15 und der Glasscheibe 12 angeordnet. Das Kabelbändchen tritt zwischen innerer 15 und äußerer Modulabdeckung 14, aus und wird analog zu der zuvor beschriebenen Festlegung nun "von außen" in dem Abstandshalter 22 festgelegt.

Um einen sicheren Kontakt zwischen Kontaktbändchen 18 und Kabelschuh 44 sicherzustellen, können diese auch miteinander verlötet werden. Um dabei eine Schädigung des Abstandshalters 22 zu verhindern, insbesondere wenn dieser aus Kunststoff besteht, sollte das Verlöten vorzugsweise vor der Befestigung des Kabelschuhs 44 und des Bändchens 18 mit dem Bolzen geschehen. Dabei ergibt sich vorteilhafterweise folgender Montageablauf:
- Sofern erforderlich (Figur 1) wird das Bändchen 18 durch die Lochbohrung 30 hindurchgeführt, so dass es einige Zentimeter nach außen hinausragt.
- Das Bändchen 18 wird im Abstand von einigen Zentimetern vom Abstandshalter 22 an den Kabelschuh 44 des elektrischen Anschlusskabels 26 gelötet.
- Der Kabelschuh 44 mit dem angelöteten Bändchen 18 wird mit dem Bolzen am Abstandshalter 22 festgelegt.

Das überstehende Bändchen 18 wird dabei in die Lochbohrung zurückgeschoben oder zusammengefaltet auf den Rücken des Abstandshalters 22 gelegt.

Weitere Vorteile und Merkmale ergeben sich aus den übrigen Anmeldungsunterlagen.

## Patentansprüche

1. Photovoltaik-Isolierverglasung umfassend eine mehrschichtige Verglasung (12, 14, 15) mit einem Photovoltaik-Modul (16), wobei Kontaktbändchen (18) zur Kontaktierung des Photovoltaik-Moduls (16) aus dem Photovoltaik-Modul (16) herausgeführt sind, und ein Abstandshalter (22) zur Beabstandung der Glasschichten (12, 14, 15) zur Bildung eines Scheibenzwischenraums (20) vorgesehen ist, wobei in dem Abstandshalter (22) mindestens eine Öffnung (30) vorgesehen ist, mittels derer das Kontaktbändchen (18) und ein elektrisches Anschlusselement (42, 26) über einen Bolzen (38, 48), der in die Öffnung (30) eingesetzt ist, festgelegt sind und wobei die Kontaktbändchen (18) mit dem außerhalb der Glasschichten (12, 14) vorgesehenen elektrischen Anschlusselement (42, 26) zusammenwirken, **dadurch gekennzeichnet, dass** der Abstandshalter (22) lediglich an seiner Außenseite eine Öffnung aufweist und das Kontaktbändchen (18) seitlich aus dem Photovoltaik-Modul herausgeführt ist und von außen mittels einem Bolzen (38, 48) in der Öffnung festgelegt ist.

2. Photovoltaik-Isolierverglasung nach Anspruch 1, **dadurch gekennzeichnet, dass** der Abstandshalter (22) mehrere Elemente und Verbindungselemente umfasst, wobei die einzelnen Elemente des Abstandshalters (22) über die Verbindungselemente (28) verbunden sind und in den Verbindungselementen (28) die Öffnungen (30) vorgesehen sind.

3. Photovoltaik-Isolierverglasung nach einem oder mehreren der vorangehenden Ansprüche, **dadurch gekennzeichnet, dass** in der Öffnung (30) ein elastischer Dichtnippel (3.4) vorgesehen ist, der insbesondere eine Gewindemutter (36) beinhaltet, zur Abdichtung des Glasscheibenzwischenraums (20) gegenüber der Außenseite der Glasschichten (12, 14).

4. Photovoltaik-Isolierverglasung nach einem oder mehreren der vorangehenden Ansprüche, **dadurch gekennzeichnet, dass** das Verbindungselement (28) aus Kunststoff besteht.

5. Photovoltaik-Isolierverglasung nach einem oder mehreren der vorangehenden Ansprüche, **dadurch gekennzeichnet, dass** die Elemente des Abstandshalters (22) auf die Verbindungselemente (28) aufgeschoben und dort verklemmt sind.

6. Photovoltaik-Isolierverglasung nach einem oder mehreren der vorangehenden Ansprüche, **dadurch gekennzeichnet, dass** die Verbindungselemente Linear- und/oder Eckverbindungselemente (28) sind.

7. Photovoltaik-Isolierverglasung nach einem oder mehreren der vorangehenden Ansprüche, **dadurch gekennzeichnet, dass** das elektrische Anschlusselement (26, 42) und/oder das Kontaktbändchen (18) mit einem Kabelschuh (44) verbunden sind.

8. Photovoltaik-Isolierverglasung nach einem oder mehreren der vorangehenden Ansprüche, **dadurch gekennzeichnet, dass** die Abstandshalterelemente (22) aus elektrisch leitenden Profilen bestehen.

9. Photovoltaik-Isolierverglasung nach einem oder mehreren der vorangehenden Ansprüche, **dadurch gekennzeichnet, dass** nicht leitfähige Unterlegscheiben vorgesehen sind; um einen elektrischen Kontakt zwischen Bolzen (38) und Abstandsprofilen (22) zu verhindern.

10. Photovoltaik-Isolierverglasung nach einem oder mehreren der vorangehenden Ansprüche, **dadurch gekennzeichnet, dass** die Öffnung (30) eine Stufenbohrung ist.

11. Photovoltaik-Isolierverglasung nach einem oder mehreren der vorangehenden Ansprüche, **dadurch gekennzeichnet, dass** die Bohrung ein Gewinde aufweist und der Bolzen, der als Gewindebolzen ausgebildet ist, hierin einschraubbar ist.

12. Photovoltaik-Isolierverglasung nach einem oder mehreren der vorangehenden Ansprüche, **dadurch gekennzeichnet, dass** der Bolzen (38) ein Blindniet (48) ist.

## Claims

1. A photo-voltaic insulating glazing, comprised of a multilayered glazing (12, 14, 15) with a photo-voltaic module (16), wherein small contact strips (18) for providing contact with the photo-voltaic module (16) project out of the photo-voltaic module (16), and a spacer (22), keeping the glass layers (12, 14, 15) apart for the formation of a pane interspace (20), is provided, wherein at least one opening (30) is provided in the spacer (22), in which the small contact strip (18) and an electrical connecting element (42, 26) are fixed in place by a bolt (38, 48), which has been inserted into the opening (30), and wherein the small contact strips (18) cooperate with the electrical connecting element (42, 26) provided outside of the glass layers (12, 14), **characterized in that** the spacer (22) has an opening only on its outside, and the small contact strip (18) has been conducted out of the side of the photo-voltaic module and is fixed in place from the outside by means of a bolt (38, 48).

2. The photo-voltaic insulating glazing in accordance with claim 1, **characterized in that** the spacer (22) is comprised of a plurality of elements and connection elements, wherein the individual elements of the spacer (22) are connected via the connection elements (28), and the openings (30) are provided in the connection elements (28).

3. The photo-voltaic insulating glazing in accordance with one or several of the preceding claims, **characterized in that** an elastic sealing nipple (34) is provided in the opening (30), which in particular contains a threaded nut (36) for sealing the glass pane interspace (20) against the outside of the glass layers (12, 14).

4. The photo-voltaic insulating glazing in accordance with one or several of the preceding claims, **characterized in that** the connection element (28) is made of plastic.

5. The photo-voltaic insulating glazing in accordance with one or several of the preceding claims, **characterized in that** the elements of the spacer (22) are pushed on the connection elements (28) and are clamped there.

6. The photo-voltaic insulating glazing in accordance with one or several of the preceding claims, **characterized in that** the connection elements are linear and/or corner connection elements (28).

7. The photo-voltaic insulating glazing in accordance with one or several of the preceding claims, **characterized in that** the electrical connecting element (42, 26) and/or the small contact strip (18) are connected with a cable socket (44).

8. The photo-voltaic insulating glazing in accordance with one or several of the preceding claims, **characterized in that** the spacer elements (22) consist of electrically conductive profiles.

9. The photo-voltaic insulating glazing in accordance with one or several of the preceding claims, **characterized in that** washers incapable of conducting are provided for preventing an electrical contact between the bolt (38) and the profiled spacers (22).

10. The photo-voltaic insulating glazing in accordance with one or several of the preceding claims, **characterized in that** the opening (30) is a stepped bore.

11. The photo-voltaic insulating glazing in accordance with one or several of the preceding claims, **characterized in that** the bore has a thread, and the bolt, which is embodied as a threaded bolt, can be screwed into it.

12. The photo-voltaic insulating glazing in accordance with one or several of the preceding claims, **characterized in that** the bolt (38) is a blind rivet (48).

## Revendications

1. Verre isolant photovoltaïque, comprenant un vitrage multicouche (12, 14, 15) comprenant un module photovoltaïque (16), les petites bandes de contact (18) pour le contact du module photovoltaïque (16) sortant de ce dernier, et un écarteur (22) pour maintenir les couches de verre à distance (12, 14, 15) afin de former un espace entre les vitres (20), l'écarteur (22) comportant au moins une ouverture (30) au moyen de laquelle la petite bande de contact (18) et un élément de branchement électrique (42, 26) sont immobilisés par un boulon (38, 48) inséré dans l'ouverture (30) et les bandes de contact (18) coopérant avec l'élément de branchement électrique (42, 26) prévu à l'extérieur des couches de verre (12, 14), **caractérisé en ce que** l'écarteur (22) présente une ouverture seulement à l'extérieur et la petite bande de contact (18) sort latéralement du module photovoltaïque et est immobilisé depuis l'extérieur dans l'ouverture au moyen d'un boulon (38, 48).

2. Verre isolant photovoltaïque selon la revendication 1, **caractérisé en ce que** l'écarteur (22) comporte plusieurs éléments et éléments de liaison, les différents éléments de l'écarteur (22) étant reliés par l'intermédiaire des éléments de liaison (28) et des ouvertures (30) étant prévues dans les éléments de liaison (28).

3. Verre isolant photovoltaïque selon l'une quelconque ou plusieurs des revendications précédentes, **caractérisé en ce que,** dans l'ouverture (30), il y a un nipple d'étanchéité élastique (34) qui contient, en particulier, un écrou fileté (36) pour fermer hermétiquement l'espace (20) entre les vitres en verre par rapport à l'extérieur des couches de verre (12, 14).

4. Verre isolant photovoltaïque selon l'une quelconque ou plusieurs des revendications précédentes, **caractérisé en ce que** l'élément de liaison (28) est en matière plastique.

5. Verre isolant photovoltaïque selon l'une quelconque ou plusieurs des revendications précédentes, **caractérisé en ce que** les éléments de l'écarteur (22) sont enfilés sur les éléments de liaison (28) où ils sont coincés.

6. Verre isolant photovoltaïque selon l'une quelconque ou plusieurs des revendications précédentes, **caractérisé en ce que** les éléments de liaison sont des éléments de liaison (28) linéaires et/ou coudés.

7. Verre isolant photovoltaïque selon l'une quelconque ou plusieurs des revendications précédentes, **caractérisé en ce que** l'élément de branchement électrique (26, 42) et/ou la petite bande de contact (18) sont reliés à une cosse (44).

8. Verre isolant photovoltaïque selon l'une quelconque ou plusieurs des revendications précédentes, **caractérisé en ce que** les écarteurs (22) sont constitués de profilés électriquement conducteurs.

9. Verre isolant photovoltaïque selon l'une quelconque ou plusieurs des revendications précédentes, **caractérisé en ce que** des cales non conductrices sont prévues pour empêcher un contact électrique entre le boulon (38) et les profilés d'écartement (22).

10. Verre isolant photovoltaïque selon l'une quelconque ou plusieurs des revendications précédentes, **caractérisé en ce que** l'ouverture (30) est un alésage étagé.

11. Verre isolant photovoltaïque selon l'une quelconque ou plusieurs des revendications précédentes, **caractérisé en ce que** l'alésage présente un filetage et le boulon, en forme de boulon fileté, peut être vissé à l'intérieur.

12. Verre isolant photovoltaïque selon l'une quelconque ou plusieurs des revendications précédentes, **caractérisé en ce que** le boulon (38) est un rivet aveugle (48).
